# EUROPEAN PATENT APPLICATION

(11) **EP 0 633 613 A1**
(43) Date of publication of application: **11.01.1995**
(21) Application number: 94201939.9
(22) Date of filing: 05.07.1994
(51) Int. Cl.: H01L 31/0216, H01L 27/148

(54) **Solid state image sensor**

(30) Priority: 06.07.1993 JP 166743/93
(71) Applicant: NIKON CORPORATION, Tokyo 100 (JP); SONY CORPORATION, Tokyo 141 (JP)
(72) Inventor: Takagi, Tadao, Yokohama-shi, Kanagawa 225 (JP); Goto, Tetsuro, Chiba 273 (JP); Iwasaki, Hiroyuki, Kawasaki-shi, Kanagawa 211 (JP); Maki, Yasuhito, c/o Sony Corporation, Shinagawa-ku, Tokyo 141 (JP)
(74) Representative: Smulders, Theodorus A.H.J., Ir.

(57) **Abstract**

This solid state image sensor includes: a number of photodiodes arranged in a plane two dimensional array in several X axis direction photodiode rows; an X axis CCD for each photodiode row, each including a number of CCD elements of which at least one corresponds to each one of the photodiodes in the corresponding photodiode row, each of the X axis CCDs transmitting in the X axis direction photoelectric conversion signals output from its corresponding photodiode row; a Y axis CCD which transmits in the Y axis direction photoelectric conversion signals which it receives from the X axis CCDs; and at least one relay CCD element for each X axis CCD, each connecting between its corresponding X axis CCD and the Y axis CCD and outputting to the Y axis CCD photoelectric conversion signals which it receives from its corresponding X axis CCD. And, the length of at least the relay CCD element which is next to the Y axis CCD is longer than the length of one of the X axis CCD elements. Optionally but desirably, the boundary between a region which receives light from an object to be photographed and which includes a number of the photodiodes, and a region over which light from the object is intercepted and which includes the Y axis CCD, lies over the relay CCD elements.

## Description

### Background of the Invention

### 1. Field of the Invention

The present invention relates to a solid state image sensor in which a plurality of photoelectric conversion elements are arranged in a plane two dimensional array.

### 2. Description of the Related Art

There is a per se known type of solid state image sensor which forms an image of an object to be photographed, and which is used in a video camera or the like.

With this type of solid state image sensor, a plurality of photodiodes (photoelectric conversion elements) are arranged in a plurality of X axis rows to form a plane two dimensional array, and X axis direction CCDs (Charge Coupled Devices) are provided in correspondence with this plurality of X axis rows of photodiodes; and further each of the X axis CCDs is connected to a single CCD in the Y axis direction via a respectively corresponding plurality of relay CCD elements.

The output signals of the photodiodes included in each X axis row of photodiodes are input in parallel to the corresponding X axis CCD, and then these signals are transmitted in series via the relay CCD elements to the single Y axis CCD. This Y axis CCD transmits the photoelectric conversion signals received from the X axis CCDs in series in the Y axis direction, and outputs them to an external image signal processing circuit.

Now, the CCDs which are provided for transmitting the output signals of the photodiodes themselves exhibit the function of photoelectric conversion, and they have the characteristic that, if strong light is incident upon their CCD elements they perform photoelectric conversion and generate electrical charges. In particular, if strong light is incident upon the Y axis CCD, the charges which are thereby generated flow to the X axis CCDs via the plurality of relay CCD elements provided between this Y axis CCD and the X axis CCDs, and, because these electric charges are undesirably added to the output signals of the photodiodes, the photoelectric conversion signals become unusable.

Accordingly, it is necessary reliably to prevent the light bundle from the object which is directed to fall upon the plurality of photodiodes from being incident upon the Y axis CCD.

However, with prior art solid state image sensors, the problem arises that, since the distance between each of the X axis CCDs and the Y axis CCD is small, the Y axis CCD comes to be not sufficiently protected from light, and therefore as described above photoelectric conversion is performed by the Y axis CCD and electric charges are generated, so that as these charges flow to the X axis CCDs the output signals of the photodiodes become unusable.

### Summary of the Invention

The objective of the present invention is to provide a solid state image sensor which is so constructed that light does not fall upon the CCD which transmits in the Y axis direction the photoelectric conversion signals which it receives from the plurality of X axis direction CCDs.

In order to achieve the above described objective, the present invention proposes a solid state image sensor comprising: a plurality of photodiodes arranged in a plane two dimensional array so as to constitute a plurality of photodiode rows each extending in the X axis direction; a plurality of X axis CCDs of which one corresponds to each one of said photodiode rows, each comprising a plurality of CCD elements of which at least one corresponds to each one of said photodiodes in the corresponding photodiode row, each of said X axis CCDs transmitting in the X axis direction photoelectric conversion signals output from its said corresponding photodiode row; a Y axis CCD which transmits in the Y axis direction photoelectric conversion signals which it receives from said plurality of X axis CCDs; and a plurality of relay CCD elements, one such relay CCD element being provided to correspond to each of said X axis CCDs and connecting between its corresponding X axis CCD and said Y axis CCD and outputting to said Y axis CCD photoelectric conversion signals which it receives from its said corresponding X axis CCD; wherein the length of the relay CCD element is longer than the length of one of said X axis CCD elements. Optionally, in this solid state image sensor, the length of the relay CCD element is at least twice the length of one of said X axis CCD elements. And, as an optional alternative, in this solid state image sensor, the boundary between a region which receives light from an object to be photographed and which includes a plurality of said photodiodes, and a region over which light from said object to be photographed is intercepted and which includes said Y axis CCD, lies over said relay CCD elements.

According to the present invention as described above, the distance between each of the X axis CCDs and the Y axis CCD is widened, and therefore it becomes harder for light from the object to be photographed which is directed upon the photodiodes to be incident upon the Y axis CCD, and thereby it is possible sufficiently to protect the Y axis CCD from light, so that accurate photoelectric conversion and accurate photometry become possible.

### Brief Description of the Drawings

Fig. 1 is a plan view showing the general construction of the preferred embodiment of the solid state image sensor of the present invention;
Fig. 2A is a figure showing a magnified view of a part of a connection portion between an X axis CCD and a Y axis CCD, included in the Fig. 1 construction; Fig. 2B is a figure showing the layered semiconductor construction of this structure in the sectional plane X-X of Fig. 2A; and Fig. 2C is a potential diagram in the sectional plane X-X of Fig. 2A;
Fig. 3 is a sectional view of a camera which is equipped with this preferred embodiment of the solid state image sensor of the present invention;
Fig. 4 is a figure showing a light receiving region of this preferred embodiment of the solid state image sensor; and:
Fig. 5 is a block diagram showing the construction of an exposure control system of the Fig. 3 camera equipped with this preferred embodiment of the solid state image sensor.

### Detailed Description of the Preferred Embodiment

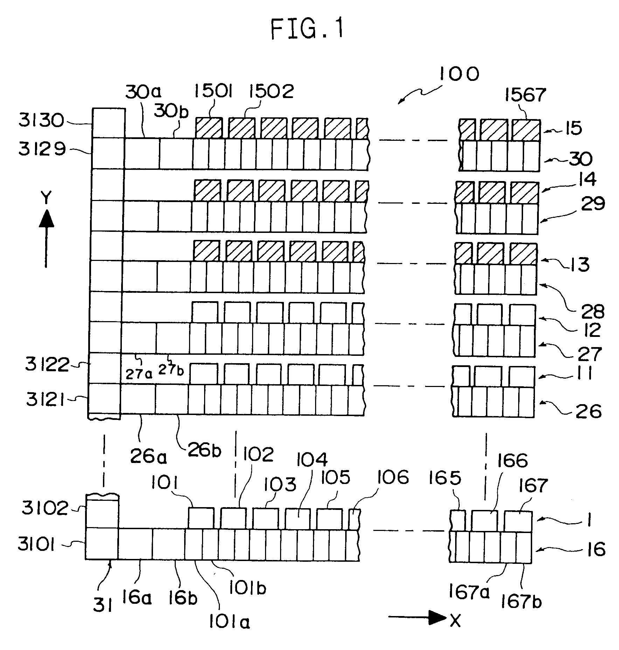

Fig. 1 is a figure showing the general construction of the preferred embodiment of the solid state image sensor of the present invention.

The solid state image sensor 100 of this preferred embodiment comprises 1005 photodiodes (photoelectric conversion elements), and these are arranged in a plane two dimensional array measuring 67 rows in the X axis (horizontal) direction and 15 rows in the Y axis (vertical) direction. The fifteen rows of these photodiodes which extend along the X axis direction and are stacked above one another in the Y axis direction will be termed photodiode row 1, photodiode row 2, ... photodiode row 15. Each of the individual photodiodes included in each of the photodiode rows 1 through 15 is designated by the conjunction of the symbol for its photodiode row (in order along the Y axis direction) with the sub-index 1 through 67 (in order along the X axis direction), so that for example the reference symbol for the fifth photodiode in the first photodiode row 1 is referred to as 105. Moreover, some of the photodiodes are not shown in Fig. 1 for the purposes of simplicity of illustration, and similarly the reference symbols for portions of the construction are omitted for clarity.

An X axis direction CCD is provided for each of the rows 1 through 15 of photodiodes, and in order along the Y axis these will be termed CCD 16, CCD 17, ... CCD 30. In each of the X axis CCDs there are provided two CCD elements corresponding to each of the photodiodes, and these CCD elements will be denoted herein by the reference symbols for their corresponding photodiodes with "a" and "b" appended. For example, the reference symbols used for the two CCD elements which correspond to the photodiode 101 will be 101a and 101b.

A CCD 31 which extends in the Y axis direction is connected to each of the X axis CCDs 16 through 30 via a corresponding pair of relay CCD elements. The two relay CCD elements between each X axis CCD 16 through 30 and the Y axis CCD 31 will be denoted by the symbol for the corresponding X axis CCD with "a" and "b" appended. For example, the reference symbols used for the two relay CCD elements between the X axis CCD 16 and the Y axis CCD 31 will be 16a and 16b. The Y axis CCD 31 comprises a pair of CCD elements corresponding to each of the X axis CCDs 16 through 30, and the reference numerals used for these CCD elements, in order along the Y axis direction, will be 3101, 3102, ... 3130.

Each of the photodiodes 101 through 1267 of the photodiode rows 1 through 12, which as will be described hereinafter are those of the photodiode rows upon which light from the object is incident, generates an electric charge corresponding to the strength of the light which is incident upon its light receiving surface, and, after the generated electric charges have been accumulated for a certain predetermined charge accumulation time period by a charge accumulation section not shown in the figures, the accumulated electric charges are output at a predetermined timing in parallel to the X axis CCDs 16 through 27, which correspond to these photodiode rows 1 through 12. These X axis CCDs 16 through 27 transmit the accumulated electric charges in the X axis direction (in the figure, in the negative direction of the X axis) according to the input of clock pulses, and these are output to the Y axis CCD 31 via the relay CCD elements 16a, 16b, ... 27a, 27b provided between the X axis CCDs 16 through 27 and the Y axis CCD 31. The Y axis CCD 31 inputs in order the electric charges transmitted upon each clock pulse from the X axis CCDs 16 through 27, and upon each clock pulse outputs along the Y axis the electric charges which were input. At the output end of the Y axis CCD 31 there is connected a floating diffusion amplifier not shown in the figures, which converts the electrical charges output into voltages and generates an image signal.

Over the surface of each of the photodiodes 1501 through 1567 in the photodiode row 15 there is provided an optically black portion which intercepts light from the charge generating surface thereof, and a dark signal is output from this photodiode row 15. Further, this dark signal is subtracted from the photoelectric conversion signal from each of the above described photodiode rows 1 through 12, so that dark signal compensation is performed for the photoelectric conversion signals, in a per se conventional fashion.

Over the surface of each of the photodiodes 1301 through 1367 and 1401 through 1467 in the photodiode rows 13 and 14 respectively there is also provided an optically black portion which intercepts light, and a signal corresponding to the temperature of the solid state image sensor 100 is output from these photodiode rows 13 and 14, and temperature correction and gamma correction are performed based upon this output signal, also in a per se conventional fashion.

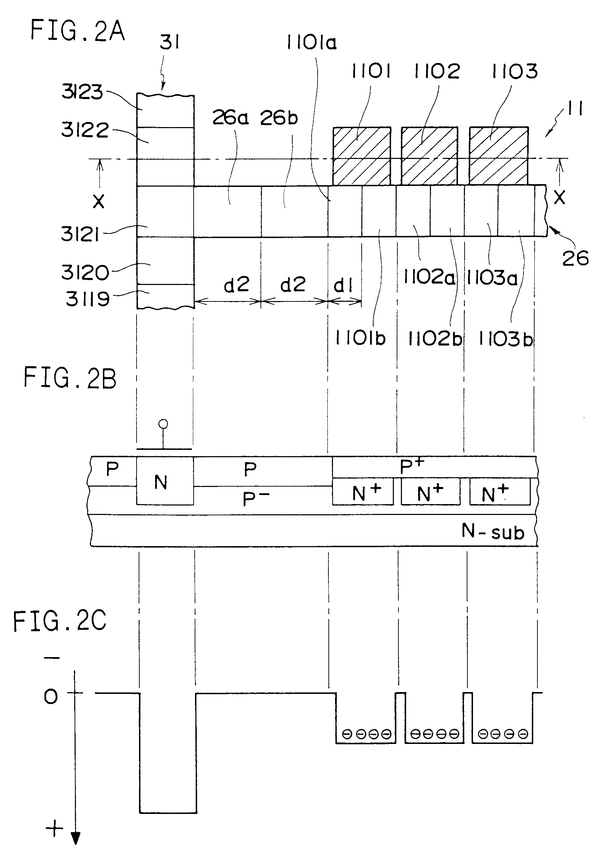

Fig. 2A shows a portion of the connecting portion between the exemplary X axis CCD 26 for the exemplary row 11 of photodiodes and the Y axis CCD 31 in magnified view; Fig. 2B shows the layered semiconductor construction of this structure in the sectional plane X-X of Fig. 2A; and Fig. 2C is a potential diagram in the sectional plane X-X of Fig. 2A.

As shown in Fig. 2A, the X axis CCD 26 is connected to the Y axis CCD 31 via the pair of relay CCD elements 26a and 26b. In this preferred embodiment, the construction is such that the relay CCD elements 26a and 26b have substantially the same identical length d2 which is substantially greater than the length d1 of each of the CCD elements 1101a, 1101b, 1102a, 1102b, 1103a, 1103b, ... comprised in the X axis CCD 26 and corresponding in respective pairs to each of the photodiodes 1101 through 1167. Moreover, although this figure does not show this, the lengths of the other relay CCD elements between the other X axis CCDs and the Y axis CCD 31 are also greater than the lengths of the other CCD elements.

In this preferred embodiment, the lengths d2 of both of the pair of relay CCD elements 26a and 26b are equal, and are greater than the lengths d1 of the CCD elements, but it will be sufficient for the purposes of the present invention if the length of at least that relay CCD element 26a which is next to the Y axis CCD 31 from among the plurality (26a and 26b) of relay CCD elements is greater than the length of the CCD elements.

Furthermore, it is desirable for the length of at least that relay CCD element 26a which is next to the Y axis CCD 31 from among the plurality (26a and 26b) of relay CCD elements to be about twice the length of the CCD elements, or longer.

In this manner, since the length d2 of at least the relay CCD element 26a which is next to the Y axis CCD 31 from among the two relay CCD elements 26a and 26b is greater than the lengths d1 of the CCD elements 1101a, 1101b, ..., ample and sufficient room is made available between the photodiodes 1101, 1102, ... and the Y axis CCD 31, and a construction is easily made possible in which, even when light from the object to be photographed is directed upon the photodiodes 1101, 1102, ..., it is possible appropriately to protect the Y axis CCD 31 from light which emanates from the object to be photographed, so that as a result it is possible to increase the light protection ability for the Y axis CCD 31, by comparison with the prior art.

It should be understood that the number of relay CCD elements which are provided between each of the X axis CCDs and the Y axis CCD, and the number of CCD elements provided for each of the photodiodes, are not limited by the details of the above described preferred embodiment.

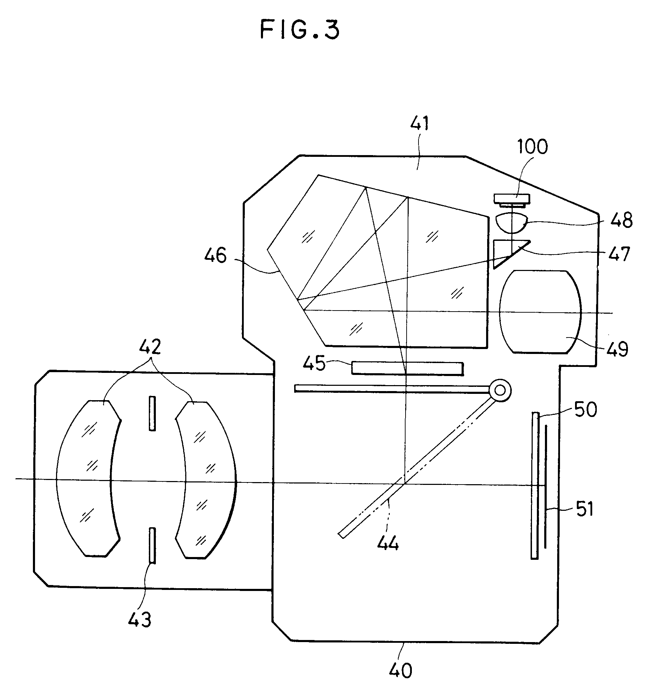

Fig. 3 is a sectional view of a camera which is equipped with the solid state image sensor 100 according to the preferred embodiment of the present invention.

The solid state image sensor 100 is provided within the viewfinder 41 of the camera 40, and is used for measuring the brightness of the object to be photographed. When performing photometry, a luminous flux from the object which has passed through a taking lens 42 and an diaphragm 43 is reflected from a main mirror 44 which is placed in the photographic path as shown by the dotted lines, and is directed upon the solid state image sensor 100 via a viewfinder screen 45, a pentaprism 46, a prism 47, and a condenser lens 48. Furthermore, the reference numeral 49 denotes an eyepiece lens, while 50 is a shutter and 51 is a film.

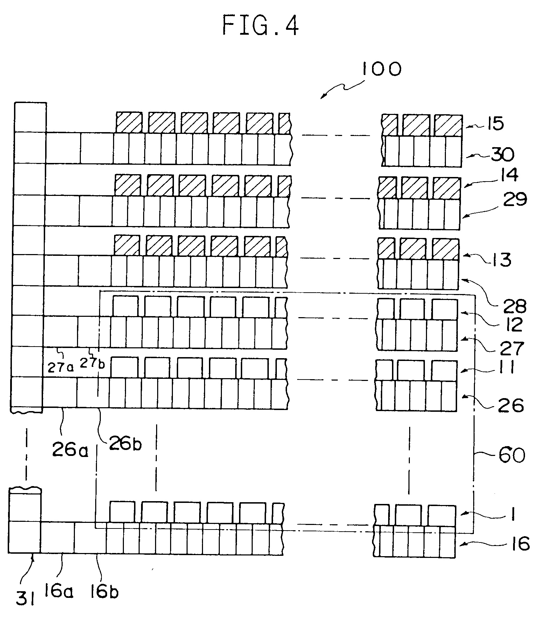

Fig. 4 is a figure showing the light receiving region 60 of the solid state image sensor 100. It should be understood that the essential features of this sensor 100 other than the light receiving region 60 are identical to those shown in Fig. 1, and therefore the explanation thereof herein will be abridged.

Light from the object is directed upon the light receiving region 60 of the solid state image sensor 100, which includes the rows 1 through 12 of photodiodes, while regions outside the light receiving region 60 including the Y axis CCD 31 are shaded, so that light from the object is not incident upon them. In this preferred embodiment of the present invention, the portion of the boundary of the light receiving region 60 which lies between the X axis CCDs 16 through 27 which correspond to the photodiode rows 1 through 12 and the Y axis CCD 31 is set over the relay CCD elements 16b, 17b, ... 27b, which are those ones of the pairs of relay CCD elements (16a and 16b, 17a and 17b, ...) which are next to the photodiodes 101, 201, ... 1201.

As described above, since the lengths of the relay CCD elements 16a, 16b, ... 27a, 27b are greater than the lengths of the CCD elements, the Y axis CCD 31 is at a position sufficiently far removed from the light receiving region 60, according to which construction it becomes difficult for light from the object which is being directed upon the light receiving region 60 to leak so as to fall upon the Y axis CCD 31, and therefore it is possible for the Y axis CCD 31 to be sufficiently protected from incidence of light.

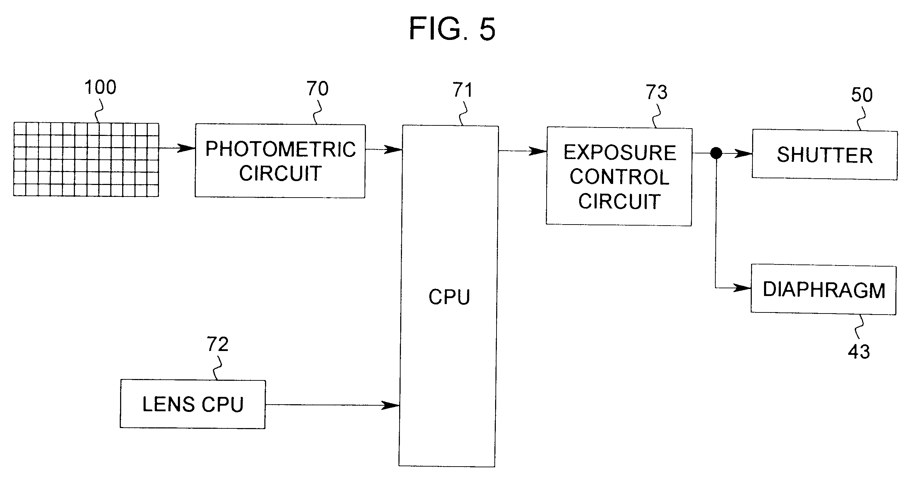

Fig. 5 is a block diagram showing the exposure control system of the camera 40 equipped with the solid state image sensor 100 of the preferred embodiment of the present invention described above.

The photoelectric conversion signals detected by the solid state image sensor 100 are output to a photometric circuit 70, and are output to a CPU 71 with the brightness of the object being calculated by the photometric circuit 70. The CPU 71 receives information relating to the taking lens 42 from a lens CPU 72 which is housed within the barrel of the taking lens 42, and calculates an exposure value BVans based upon this information and upon the brightness of the object. And, when the shutter 50 is released, the exposure control circuit 73 is controlled according to the exposure value BVans so as to drive the shutter 50 and the diaphragm 43, whereby the film 51 is exposed to light.

Although the present invention has been shown and described in terms of a preferred embodiment thereof, it is not to be considered as limited by any of the perhaps quite fortuitous details of said embodiment or of the drawings, but only by the terms of the appended claims, which follow.

## Claims

1. A solid state image sensor, comprising:
a plurality of photodiodes arranged in a plane two dimensional array so as to constitute a plurality of photodiode rows each extending in the X axis direction;
a plurality of X axis CCDs of which one corresponds to each one of said photodiode rows, each comprising a plurality of CCD elements of which at least one corresponds to each one of said photodiodes in the corresponding photodiode row, each of said X axis CCDs transmitting in the X axis direction photoelectric conversion signals output from its said corresponding photodiode row;
a Y axis CCD which transmits in the Y axis direction photoelectric conversion signals which it receives from said plurality of X axis CCDs; and:
a plurality of relay CCD elements, one such relay CCD element being provided to correspond to each of said X axis CCDs and connecting between its corresponding X axis CCD and said Y axis CCD and outputting to said Y axis CCD photoelectric conversion signals which it receives from its said corresponding X axis CCD; wherein:
the length of the relay CCD element is longer than the length of one of said X axis CCD elements.

2. A solid state image sensor according to Claim 1, wherein the length of the relay CCD element is at least twice the length of one of said X axis CCD elements.

3. A solid state image sensor according to Claim 1, wherein the boundary between a region which receives light from an object to be photographed and which includes a plurality of said photodiodes, and a region over which light from said object to be photographed is intercepted and which includes said Y axis CCD, lies over said relay CCD elements.

4. A solid state image sensor according to Claim 1, wherein exactly two of said X axis CCD elements are provided to correspond to each one of said photodiodes in the corresponding photodiode row, and exactly two of said relay CCD elements are provided to correspond to each one of said X axis CCDs.

5. A solid state image sensor, comprising:
a plurality of photodiodes arranged in a plane two dimensional array so as to constitute a plurality of photodiode rows each extending in the X axis direction;
a plurality of X axis CCDs of which one corresponds to each one of said photodiode rows, each comprising a plurality of CCD elements of which at least one corresponds to each one of said photodiodes in the corresponding photodiode row, each of said X axis CCDs transmitting in the X axis direction photoelectric conversion signals output from its said corresponding photodiode row;
a Y axis CCD which transmits in the Y axis direction photoelectric conversion signals which it receives from said plurality of X axis CCDs; and:
a plurality of relay CCD element sets each comprising a plurality of relay CCD elements arranged in sequence, one such relay CCD element set being provided to correspond to each of said X axis CCDs and connecting between its corresponding X axis CCD and said Y axis CCD and outputting to said Y axis CCD photoelectric conversion signals which it receives from its said corresponding X axis CCD; wherein:
in each said relay CCD element set, the length of at least the relay CCD element comprised therein which is next to said Y axis CCD is longer than the length of one of said X axis CCD elements.

6. A solid state image sensor according to Claim 5, wherein, in each said relay CCD element set, the length of at least the relay CCD element comprised therein which is next to said Y axis CCD is at least twice the length of one of said X axis CCD elements.

7. A solid state image sensor according to Claim 5, wherein the boundary between a region which receives light from an object to be photographed and which includes a plurality of said photodiodes, and a region over which light from said object to be photographed is intercepted and which includes said Y axis CCD, lies over the relay CCD element which is next to said X axis CCD in each said relay CCD element set.

8. A solid state image sensor according to Claim 5, wherein exactly two of said X axis CCD elements are provided to correspond to each one of said photodiodes in the corresponding photodiode row, and exactly two of said relay CCD elements are provided to correspond to each one of said relay CCD element sets.

9. A solid state image sensor, comprising:
a plurality of photoelectric conversion elements arranged in a plane two dimensional array so as to constitute a plurality of photoelectric conversion element rows each extending in the X axis direction;
a plurality of X axis transmission means of which one corresponds to each one of said photoelectric conversion element rows, each comprising a plurality of transmission elements of which at least one corresponds to each one of said photoelectric conversion elements in the corresponding photoelectric conversion element row, each of said X axis transmission means transmitting in the X axis direction photoelectric conversion signals output from its said corresponding photoelectric conversion element row;
a Y axis transmission means which transmits in the Y axis direction photoelectric conversion signals which it receives from said plurality of X axis transmission means; and:
a plurality of relay elements, one such relay element being provided to correspond to each of said X axis transmission means and connecting between its corresponding X axis transmission means and said Y axis transmission means and outputting to said Y axis transmission means photoelectric conversion signals which it receives from its said corresponding X axis transmission means; wherein:
the length of the relay element is longer than the length of one of said transmission elements.

10. A solid state image sensor according to Claim 9, wherein the length of the relay element is at least twice the length of one of said transmission elements.

11. A solid state image sensor according to Claim 9, wherein the boundary between a region which receives light from an object to be photographed and which includes a plurality of said photoelectric conversion elements, and a region over which light from said object to be photographed is intercepted and which includes said Y axis transmission means, lies over said relay elements.

12. A solid state image sensor according to Claim 9, wherein exactly two of said transmission elements are provided to correspond to each one of said photoelectric conversion elements in the corresponding photoelectric conversion element row, and exactly two of said relay elements are provided to correspond to each one of said X axis transmission means.

13. A solid state image sensor, comprising:
a plurality of photoelectric conversion elements arranged in a plane two dimensional array so as to constitute a plurality of photoelectric conversion element rows each extending in the X axis direction;
a plurality of X axis transmission means of which one corresponds to each one of said photoelectric conversion element rows, each comprising a plurality of transmission elements of which at least one corresponds to each one of said photoelectric conversion elements in the corresponding photoelectric conversion element row, each of said X axis transmission means transmitting in the X axis direction photoelectric conversion signals output from its said corresponding photoelectric conversion element row;
a Y axis transmission means which transmits in the Y axis direction photoelectric conversion signals which it receives from said plurality of X axis transmission means; and:
a plurality of relay element sets each comprising a plurality of relay elements arranged in sequence, one such relay element set being provided to correspond to each of said X axis transmission means and connecting between its corresponding X axis transmission means and said Y axis transmission means and outputting to said Y axis transmission means photoelectric conversion signals which it receives from its said corresponding X axis transmission means; wherein:
in each said relay element set, the length of at least the relay element comprised therein which is next to said Y axis transmission means is longer than the length of one of said transmission elements.

14. A solid state image sensor according to Claim 13, wherein, in each said relay element set, the length of at least the relay element comprised therein which is next to said Y axis transmission means is at least twice the length of one of said transmission elements.

15. A solid state image sensor according to Claim 13, wherein the boundary between a region which receives light from an object to be photographed and which includes a plurality of said photoelectric conversion elements, and a region over which light from said object to be photographed is intercepted and which includes said Y axis transmission means, lies over said relay elements.

16. A solid state image sensor according to Claim 13, wherein exactly two of said transmission elements are provided to correspond to each one of said photoelectric conversion elements in the corresponding photoelectric conversion element row, and exactly two of said relay elements are provided to correspond to each one of said relay element sets.
